# EUROPEAN PATENT APPLICATION

(11) **EP 3 979 508 A1**
(43) Date of publication of application: **06.04.2022**
(21) Application number: 20834584.3
(22) Date of filing: 19.06.2020
(51) Int. Cl.: H04B 1/38

(54) **DISPLAY SCREEN ASSEMBLY, ANTENNA ASSEMBLY, AND ELECTRONIC APPARATUS**

(30) Priority: 30.06.2019 CN 201910588888
(71) Applicant: GUANGDONG OPPO MOBILE TELECOMMUNICATIONS CORP., LTD., Dongguan, Guangdong 523860 (CN)
(72) Inventor: JIA, Yuhu, Dongguan, Guangdong 523860 (CN)
(74) Representative: Mewburn Ellis LLP
(86) International application number: PCT/CN2020/096942
(87) International publication number: WO 2021/000746

(57) **Abstract**

A display screen assembly, an antenna assembly, and an electronic device are provided according to the present disclosure. The display screen assembly includes a display screen body and a radio-wave transparent structure. The display screen body has a first transmittance to a radio frequency (RF) signal in a preset frequency band. The radio-wave transparent structure is carried on the display screen body and covers at least part of the display screen body. The display screen assembly has a second transmittance to the RF signal in the preset frequency band in a region corresponding to the radio-wave transparent structure, and the second transmittance is greater than the first transmittance. In the display screen assembly provided in the present disclosure, the radio-wave transparent structure is carried on the display screen body. The transmittance to the RF signal in the preset frequency band can be improved with aid of the radio-wave transparent structure. In case that the display screen assembly is applied to an electronic device, influence of the display screen assembly on radiation performance of an antenna module disposed inside the electronic device can be reduced, as such, communication performance of the electronic device can be improved.

## Description

### CROSS-REFERENCE TO RELATED APPLICATION(S)

This disclosure claims priority to and the benefit of Chinese Patent Application Serial No. 201910588888.8, filed on June 30, 2019, and entitled "DISPLAY SCREEN ASSEMBLY, ANTENNA ASSEMBLY, AND ELECTRONIC DEVICE", the entire disclosure of which is hereby incorporated by reference.

### TECHNICAL FIELD

This disclosure relates to the field of electronic devices, and in particular, to a display screen assembly, an antenna assembly, and an electronic device.

### BACKGROUND

With the development of mobile communication technology, the traditional fourth generation (4G) mobile communication cannot meet user requirements. The fifth generation (5G) mobile communication is favored by users due to its high communication speed. For example, a data transmission speed in the 5G mobile communication is hundreds of times higher than that in the 4G mobile communication. The 5G mobile communication is mainly implemented via millimeter wave signals. However, in case that a millimeter wave antenna is applied to an electronic device, the millimeter wave antenna is generally disposed within an accommodation space inside the electronic device, and due to a relatively low transmittance of a screen of the electronic device to the millimeter wave signal, requirements of antenna radiation performance cannot be met. Alternatively, the screen of the electronic device has a relatively low transmittance to external millimeter wave signals. As a result, poor communication performances of 5G millimeter waves are often incurred.

### SUMMARY

A display screen assembly, an antenna assembly, and an electronic device are provided in the present disclosure, so as to solve a technical problem that a traditional screen of an electronic device has a low transmittance to millimeter wave signals.

According to a first aspect, a display screen assembly is provided. The display screen includes a display screen body and a radio-wave transparent structure. The display screen body has a first transmittance to a radio frequency (RF) signal in a preset frequency band. The radio-wave transparent structure is carried on the display screen body and covers at least part of the display screen body. The display screen assembly has a second transmittance to the RF signal in the preset frequency band in a region corresponding to the radio-wave transparent structure, and the second transmittance is greater than the first transmittance.

According to a second aspect, an antenna assembly is provided. The antenna assembly includes an antenna module and the display screen assembly provided in the first aspect. The antenna module is configured to emit and receive, within a preset range, the RF signal in the preset frequency band. The radio-wave transparent structure in the display screen assembly is at least partially located within the preset range.

According to a third aspect, an electronic device is provided. The electronic device includes the antenna assembly provided in the second aspect.

According to a fourth aspect, an electronic device is provided. The electronic device includes a first antenna module, a display screen body, and a first radio-wave transparent structure. The first antenna module is configured to emit and receive, within a first preset direction range, a first radio frequency (RF) signal in a first frequency band. The display screen body is spaced apart from the first antenna module and at least partially located within the first preset direction range, and has a first transmittance to the RF signal in a preset frequency band. The first radio-wave transparent structure is carried on the display screen body. The first radio-wave transparent structure covers at least part of the display screen body and is at least partially located within the first preset direction range. The electronic device has a second transmittance to the first RF signal in the first frequency band in a region corresponding to the first radio-wave transparent structure, and the second transmittance is greater than the first transmittance.

### BRIEF DESCRIPTION OF THE DRAWINGS

To describe technical solutions in the implementations of the present disclosure more clearly, the accompanying drawings required for describing the implementations will be briefly introduced below. Apparently, the accompanying drawings in the following description merely illustrate some implementations of the present disclosure. Those of ordinary skill in the art may also obtain other drawings based on these accompanying drawings without creative efforts.
FIG. 1 is a schematic structural view of a display screen assembly provided in a first implementation of the present disclosure.
FIG. 2 is a schematic structural view of a display screen assembly provided in a second implementation of the present disclosure.
FIG. 3 is a schematic cross-sectional structural view of an array substrate illustrated in FIG. 2.
FIG. 4 is a schematic cross-sectional structural view of an array substrate of a display screen assembly provided in a third implementation of the present disclosure.
FIG. 5 is a schematic cross-sectional structural view of an array substrate of a display screen assembly provided in a fourth implementation of the present disclosure.
FIG. 6 is a schematic cross-sectional structural view of an array substrate of a display screen assembly provided in a fifth implementation of the present disclosure.
FIG. 7 is a schematic cross-sectional structural view of the array substrate of the display screen assembly provided in the fifth implementation of the present disclosure.
FIG. 8 is a schematic cross-sectional structural view of an array substrate of a display screen assembly provided in a sixth implementation of the present disclosure.
FIG. 9 is a schematic structural view of a display screen assembly provided in a seventh implementation of the present disclosure.
FIG. 10 is a schematic structural view of a display screen assembly provided in an eighth implementation of the present disclosure.
FIG. 11 is a schematic structural view of a display screen assembly provided in a ninth implementation of the present disclosure.
FIG. 12 is a schematic cross-sectional structural view of the display screen assembly illustrated in FIG. 11.
FIG. 13 is a schematic structural view of a display screen assembly provided in a tenth implementation of the present disclosure.
FIG. 14 is a schematic cross-sectional structural view of the display screen assembly illustrated in FIG. 13.
FIG. 15 is a schematic structural view of a display screen assembly provided in an eleventh implementation of the present disclosure.
FIG. 16 is a schematic structural view of a display screen assembly provided in a twelfth implementation of the present disclosure.
FIG. 17 is a schematic structural view of a radio-wave transparent structure provided in the first implementation of the present disclosure.
FIG. 18 is a schematic structural view of a radio-wave transparent structure provided in the second implementation of the present disclosure.
FIG. 19 is a schematic structural view of a radio-wave transparent structure provided in the third implementation of the present disclosure.
FIG. 20 is a schematic cross-sectional structural view of a radio-wave transparent structure provided in the fourth implementation of the present disclosure.
FIG. 21 is a schematic structural view of a first radio-wave transparent layer of the radio-wave transparent structure provided in the fourth implementation of the present disclosure.
FIG. 22 is a schematic structural view of a second radio-wave transparent layer of the radio-wave transparent structure provided in the fourth implementation of the present disclosure.
FIG. 23 is an equivalent circuit diagram of the radio-wave transparent structure provided in the fourth implementation of the present disclosure.
FIG. 24 is a schematic structural view of a first radio-wave transparent layer of a radio-wave transparent structure provided in the fifth implementation of the present disclosure.
FIG. 25 is a schematic structural view of a first radio-wave transparent layer of a radio-wave transparent structure provided in the sixth implementation of the present disclosure.
FIG. 26 is a schematic structural view of a first radio-wave transparent layer of a radio-wave transparent structure provided in the seventh implementation of the present disclosure.
FIG. 27 is a schematic structural view of a first radio-wave transparent layer of a radio-wave transparent structure provided in the eighth implementation of the present disclosure.
FIG. 28 is a schematic structural view of an antenna assembly provided in the present disclosure.
FIG. 29 is a schematic structural view of an electronic device provided in the first implementation of the present disclosure.
FIG. 30 is a schematic structural view of an electronic device provided in the second implementation of the present disclosure.
FIG. 31 is a schematic cross-sectional structural view along line III-III of FIG. 30.
FIG. 32 is a schematic structural view of an electronic device provided in the third implementation of the present disclosure.
FIG. 33 is a schematic cross-sectional structural view along line IV-IV of FIG. 32.
FIG. 34 is a schematic cross-sectional structural view of an antenna module provided in an implementation of the present disclosure.
FIG. 35 is a schematic cross-sectional structural view of an antenna module provided in another implementation of the present disclosure.
FIG. 36 is a schematic view of an RF antenna array constructed with *M* × *N* antenna assemblies provided in an implementation of the present disclosure.
FIG. 37 is a schematic structural view of an RF antenna array constructed with packaged antenna modules provided in an implementation of the present disclosure.
FIG. 38 is a schematic structural view of an electronic device provided in the fourth implementation of the present disclosure.
FIG. 39 is a schematic structural view of an electronic device provided in the fifth implementation of the present disclosure.
FIG. 40 is a schematic structural view of an electronic device provided in the sixth implementation of the present disclosure.
FIG. 41 is a schematic structural view of an electronic device provided in the seventh implementation of the present disclosure.

### DETAILED DESCRIPTION

In a first aspect, a display screen assembly is provided. The display screen assembly includes a display screen body and a radio-wave transparent structure. The display screen body has a first transmittance to a radio frequency (RF) signal in a preset frequency band. The radio-wave transparent structure is carried on the display screen body and covers at least part of the display screen body. The display screen assembly has a second transmittance to the RF signal in the preset frequency band in a region corresponding to the radio-wave transparent structure, and the second transmittance is greater than the first transmittance.

In a first implementation of the first aspect, the display screen body includes a display screen and a cover plate stacked with the display screen, and the radio-wave transparent structure is disposed on the cover plate.

In a second implementation of the first aspect, the display screen body includes an array substrate. The array substrate includes a substrate and multiple thin film transistors arranged in an array on the substrate. The thin film transistor includes a gate, a gate insulating layer, a channel layer, a source, and a drain. The gate is disposed on one side of the substrate. The gate insulating layer covers the gate. The channel layer is disposed on the gate insulating layer and corresponds to the gate. The source and the drain are disposed at opposite ends of the channel layer and spaced apart from each other, and the source and the drain are both connected to the channel layer. The radio-wave transparent structure is a single-layer structure, and the radio-wave transparent structure is disposed in the same layer as the gate or disposed in the same layer as the source and the drain.

In a third implementation of the first aspect, the display screen body includes an array substrate. The array substrate includes a substrate and multiple thin film transistors arranged in an array on the substrate. The thin film transistor includes a gate, a gate insulating layer, a channel layer, a source, and a drain. The gate is disposed on one side of the substrate. The gate insulating layer covers the gate. The channel layer is disposed on the gate insulating layer and corresponds to the gate. The source and the drain are disposed at opposite ends of the channel layer and spaced apart from each other, and the source and the drain are both connected to the channel layer. The radio-wave transparent structure includes a first radio-wave transparent layer and a second radio-wave transparent layer which are stacked and spaced apart from each other. The first radio-wave transparent layer is disposed in the same layer as the gate, and the second radio-wave transparent layer is disposed in the same layer as the source and the drain.

In a fourth implementation of the first aspect, the display screen body includes an array substrate. The array substrate includes a substrate and multiple thin film transistors arranged in an array on the substrate. The thin film transistor includes a light-shielding layer, a first insulating layer, a channel layer, a source, a drain, a second insulating layer, a gate, and a planarization layer. The light-shielding layer is disposed on one side of the substrate. The first insulating layer covers the light-shielding layer. The channel layer is disposed on the first insulating layer and corresponds to the light-shielding layer. The source and the drain are disposed at opposite ends of the channel layer and spaced apart from each other. The source and the drain are both connected to the channel layer. The second insulating layer covers the source and the drain. The gate is disposed on the second insulating layer. The radio-wave transparent structure is a single-layer structure. The radio-wave transparent structure is disposed in the same layer as one of the light-shielding layer and the gate or disposed in the same layer as the source and the drain.

In a fifth implementation of the first aspect, the display screen body includes an array substrate. The array substrate includes a substrate and multiple thin film transistors arranged in an array on the substrate. The thin film transistor includes a light-shielding layer, a first insulating layer, a channel layer, a source, a drain, a second insulating layer, a gate, and a planarization layer. The light-shielding layer is disposed on one side of the substrate. The first insulating layer covers the light-shielding layer. The channel layer is disposed on the first insulating layer and corresponds to the light-shielding layer. The source and the drain are disposed at opposite ends of the channel layer and spaced apart from each other. The source and the drain are both connected to the channel layer. The second insulating layer covers the source and the drain. The gate is disposed on the second insulating layer. The radio-wave transparent structure includes a first radio-wave transparent layer and a second radio-wave transparent layer which are stacked and spaced apart from each other. The first radio-wave transparent layer is disposed in the same layer as one of the light-shielding layer, the gate, and the source, and the second radio-wave transparent layer is disposed in the same layer as another one of the light-shielding layer, the gate, and the source.

In a sixth implementation of the first aspect, the display screen body includes an array substrate. The array substrate includes a substrate and multiple thin film transistors arranged in an array on the substrate. The thin film transistor includes a light-shielding layer, a first insulating layer, a channel layer, a source, a drain, a second insulating layer, a gate, and a planarization layer. The light-shielding layer is disposed on one side of the substrate. The first insulating layer covers the light-shielding layer, the channel layer is disposed on the first insulating layer and corresponds to the light-shielding layer. The source and the drain are disposed at opposite ends of the channel layer and spaced apart from each other. The source and the drain are both connected to the channel layer. The second insulating layer covers the source and the drain. The gate is disposed on the second insulating layer. The radio-wave transparent structure includes a first radio-wave transparent layer, a second radio-wave transparent layer, and a third radio-wave transparent layer which are stacked and spaced apart from one another. The first radio-wave transparent layer is disposed in the same layer as the light-shielding layer. The second radio-wave transparent layer is disposed in the same layer as the gate. The third radio-wave transparent layer is disposed in the same layer as the drain.

In a seventh implementation of the first aspect, the display panel includes an array substrate including a pixel electrode. The pixel electrode is a semiconductor made of a transparent metal oxide material. The radio-wave transparent structure is at least partially disposed in the same layer as the pixel electrode and made of the same material as the pixel electrode.

In an eighth implementation of the first aspect, the display panel includes an array substrate and a color filter substrate which are arranged opposite to and spaced apart from each other. The radio-wave transparent structure includes a first radio-wave transparent layer and a second radio-wave transparent layer. The first radio-wave transparent layer is disposed on the array substrate. The second radio-wave transparent layer is disposed on the color filter substrate.

In a ninth implementation of the display screen assembly according to the eighth implementation of the first aspect, the color filter substrate includes a pixel electrode. The array substrate includes a common electrode. The first radio-wave transparent layer is disposed in the same layer as the pixel electrode. The second radio-wave transparent layer is disposed in the same layer as the common electrode.

In a tenth implementation of the first aspect, the display screen body includes a substrate and light-emitting elements arranged in an array on the substrate. The light-emitting element includes a first electrode, a light-emitting layer, and a second electrode. The first electrode is disposed more adjacent to the substrate than the light-emitting layer and the second electrode. The light-emitting layer is disposed on one side of the first electrode away from the substrate. The second electrode is disposed on one side of the light-emitting layer away from the first electrode. The first electrode is configured to load a first voltage, the second electrode is configured to load a second voltage. The light-emitting layer is configured to emit light under action of the first voltage and the second voltage. The radio-wave transparent structure is a single-layer structure. The radio-wave transparent structure is disposed in the same layer as one of the first electrode and the second electrode.

In an eleventh implementation of the first aspect, the display screen body includes a substrate and light-emitting elements arranged in an array on the substrate. The light-emitting element includes a first electrode, a light-emitting layer, and a second electrode. The first electrode is disposed more adjacent to the substrate than the light-emitting layer and the second electrode. The light-emitting layer is disposed on one side of the first electrode away from the substrate. The second electrode is disposed on one side of the light-emitting layer away from the first electrode. The first electrode is configured to load a first voltage. The second electrode is configured to load a second voltage. The light-emitting layer is configured to emit light under action of the first voltage and the second voltage. The radio-wave transparent structure includes a first radio-wave transparent layer and a second radio-wave transparent layer. The first radio-wave transparent layer is disposed in the same layer as the first electrode. The second radio-wave transparent layer is disposed in the same layer as the second electrode.

In a twelfth implementation of the display screen assembly according to the tenth or eleventh implementation of the first aspect, the first electrode is an anode and the second electrode is a cathode. Alternatively, the first electrode is the cathode and the second electrode is the anode.

In a thirteenth implementation of the display screen assembly according to any of the third, fifth, eighth, and eleventh implementations of the first aspect, the first radio-wave transparent structure defines a through hole. An orthographic projection of the second radio-wave transparent structure on the first radio-wave transparent structure falls within the through hole.

In a fourteenth implementation of the first aspect, the display screen body includes an inner surface and an outer surface opposite to the inner surface, and the radio-wave transparent structure is disposed on the inner surface.

In fifteenth implementation of the first aspect, the display screen body includes a screen body and an extending portion bent and extended from a periphery of the screen body. The radio-wave transparent structure is disposed corresponding to one of the screen body and the extending portion.

In a second aspect, an antenna assembly is provide. The antenna assembly includes an antenna module and the display screen assembly provided in the first aspect or any of the first to fifteenth implementations of the first aspect, the antenna module is configured to emit and receive, within a preset range, the RF signal in the preset frequency band. The radio-wave transparent structure in the display screen assembly is at least partially located within the preset range.

In a third aspect, an electronic device is provided. The electronic device includes the antenna assembly provided in the second aspect.

In a fourth aspect, an electronic device is provided. The electronic device includes a first antenna module, a display screen body, and a first radio-wave transparent structure. The first antenna module is configured to emit and receive, within a first preset direction range, a first radio frequency (RF) signal in a first frequency band. The display screen body is spaced apart from the first antenna module and at least partially located within the first preset direction range, and has a first transmittance to the RF signal in a preset frequency band. The first radio-wave transparent structure is carried on the display screen body. The first radio-wave transparent structure covers at least part of the display screen body and is at least partially located within the first preset direction range. The electronic device has a second transmittance to the first RF signal in the first frequency band in a region corresponding to the first radio-wave transparent structure, and the second transmittance is greater than the first transmittance.

In a first implementation of the fourth aspect, the electronic device further includes a second antenna module and a second radio-wave transparent structure. The second antenna module is spaced apart from the first antenna module and located outside the first preset direction range. The second antenna module is configured to emit and receive, within a second preset direction range, a second RF signal in a second frequency band. The display screen body is spaced apart from the second antenna module and at least partially located within the second preset direction range. A part of the display screen body within the second preset direction range has a third transmittance to the second RF signal in the second frequency band. The second radio-wave transparent structure is carried on the display screen body. The second radio-wave transparent structure is at least partially located within the second preset direction range. The electronic device has a fourth transmittance to the second RF signal in the first frequency band in a region corresponding to the second radio-wave transparent structure, and the fourth transmittance is greater than the third transmittance.

In a second implementation of the electronic device according to the first implementation of the fourth aspect, the display screen body includes a screen body and an extending portion bent and extended from a periphery of the screen body. The first antenna module and the second antenna module are both disposed corresponding to one of the screen body or the extending portion. Alternatively, the first antenna module is disposed corresponding to the screen body, and the second antenna module is disposed corresponding to the extending portion.

The technical solutions in the implementations of the present disclosure are clearly and completely described in the following with reference to the accompanying drawings in the implementations of the present disclosure. Apparently, the described implementations are merely a part of rather than all the implementations of the present disclosure. All other implementations obtained by those of ordinary skill in the art based on the implementations of the present disclosure without creative efforts are within the scope of the present disclosure.

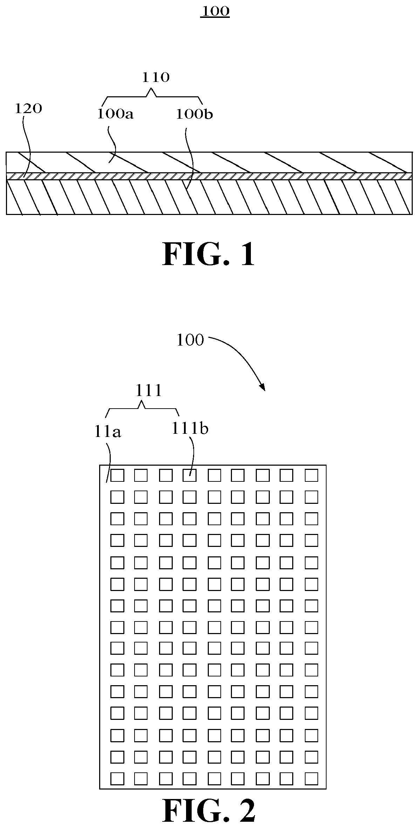

FIG. 1 is a schematic structural view of a display screen assembly provided in a first implementation of the present disclosure. The display screen assembly 100 includes a display screen body 110 and a radio-wave transparent structure 120. The display screen body 110 has a first transmittance to a radio frequency (RF) signal in a preset frequency band. The radio-wave transparent structure 120 is carried on the display screen body 110 and covers at least part of the display screen body 110. The display screen assembly 100 has a second transmittance to the RF signal in the preset frequency band in a region corresponding to the radio-wave transparent structure 120, and the second transmittance is greater than the first transmittance.

The radio-wave transparent structure 120 may be directly disposed on the display screen body 110. Alternatively, the radio-wave transparent structure 120 may be disposed on the display screen body 110 via a bearing film, or may be embedded in the display screen body 110. In case that the radio-wave transparent structure 120 is disposed on the display screen body 110 via the bearing film, the bearing film may be, but not limited to, a plastic (for example, polyethylene terephthalate (PET)) film, a flexible circuit board, a printed circuit board, or the like. The PET film may be, but not limited to, a color film, an explosion-proof film, or the like. The radio-wave transparent structure 120 may cover part of the display screen body 110. Alternatively, the radio-wave transparent structure 120 may cover the entire display screen body 110. The display screen body 110 includes an inner surface and an outer surface opposite to the inner surface. The radio-wave transparent structure 120 can be disposed on the inner surface of the display screen body 110 or on the outer surface of the display screen body 110.

The display screen body 110 may refer to a component that performs a display function in an electronic device. Generally, the display screen body 100 can include a display screen 100a and a cover plate 100b stacked with the display screen 100a. The display screen 100a can be a liquid crystal display or an organic light-emitting diode display. The cover plate 100b can be disposed on the display screen 100a for protecting the display screen 100a. In this implementation, the radio-wave transparent structure 120 is disposed on the cover plate 100b. The radio-wave transparent structure 120 can be disposed on one surface of the cover plate 100b close to the display screen 100a. Alternatively, the radio-wave transparent structure 120 can also be disposed on the other surface of the cover plate 100b away from the display screen 100a. Alternatively, the radio-wave transparent structure 120 can be embedded in the cover plate 100b. Because the cover plate 100b is an independent component, when the radio-wave transparent structure 120 is disposed on the surface of the cover plate 100b close to the display screen 100a or on the other surface of the cover plate 100b away from the display screen 100a, the difficulty of combining the radio-wave transparent structure 120 with the display screen body 110 can be reduced. Referring to FIG. 1, an example that the radio-wave transparent structure 120 covers the entire cover plate 100b and the radio-wave transparent structure 120 is directly disposed on the surface of the cover plate 100b close to the display screen 100a is given for illustration.

The radio-wave transparent structure 120 can have any of the following characteristics: single-frequency single-polarization, single-frequency dual-polarization, dual-frequency dual-polarization, dual-frequency single-polarization, wide-band single-polarization, wide-band dual-polarization, and the like. Accordingly, the radio-wave transparent structure 120 can also have any of the following characteristics: dual-frequency resonance response, single-frequency resonance response, wide-frequency resonance response, multi-frequency resonance response, and the like. The radio-wave transparent structure 120 may be made of a metal material or a non-metal conductive material.

On the one hand, the radio-wave transparent structure 120 on the display screen body 110 can be excited by the RF signal in the preset frequency band, and the radio-wave transparent structure 120 can generate an RF signal in the same frequency band as the preset frequency band according to the RF signal in the preset frequency band. The RF signal generated by the radio-wave transparent structure 120 can pass through the dielectric substrate 110 and radiate into free space. Because the radio-wave transparent structure 120 can be excited to generate the RF signal in the same frequency band as the preset frequency band, more RF signals in the preset frequency band can pass through the dielectric substrate 110 to radiate into the free space. In other words, the display screen assembly 100 has an improved transmittance to the RF signal in the preset frequency band with aid of the radio-wave transparent structure 120.

On the other hand, the display screen assembly 100 includes the radio-wave transparent structure 120 and the display screen body 110. In this case, a dielectric constant of the display screen assembly 100 can be equivalent to a dielectric constant of a preset material. The preset material has a relatively high transmittance to the RF signal in the preset frequency band, and an equivalent wave impedance of the preset material is equal to or approximately equal to an equivalent wave impedance in the free space.

The RF signal may be, but is not limited to, an RF signal in the millimeter wave band or the terahertz band. Currently, in 5^{th} generation (5G) wireless communication systems, under the protocol of the 3GPP 38.101, frequency bands for 5G NR (new radio) are mainly divided into two different frequency ranges: frequency range 1 (FR1) and frequency range 2 (FR2). The FR1 band has a frequency range of 450 MHz ~ 6 GHz, and is also known as the "sub-6 GHz" band. The FR2 band has a frequency range of 24.25 GHz ~ 52.6 GHz, and belongs to the millimeter wave (mm Wave) band. 3GPP Release 15 specifies that the current 5G millimeter wave bands include bands n257 (26.5 GHz ~ 29.5 GHz), n258 (24.25 GHz ~ 27.5 GHz), n261 (27.5 GHz ~ 28.35 GHz), and n260 (37 GHz ~ 40 GHz).

In the display screen assembly 100 provided in the present disclosure, the radio-wave transparent structure 120 is carried on the display screen body 110. The transmittance to the RF signal in the preset frequency band is improved with aid of the radio-wave transparent structure 120. In case that the display screen assembly 100 is applied to an electronic device 1, influence of the display screen assembly 100 on radiation performance of an antenna module disposed inside the electronic device 1 can be reduced, as such, communication performance of the electronic device 1 can be improved.

In an example, the radio-wave transparent structure 120 has a transmittance to visible light ("light transmittance" for short) greater than a preset transmittance, so that the display screen body 110 can display normally. The preset transmittance may be but is not limited to 80%. Because the radio-wave transparent structure 120 is applied to the display screen body 110 and the light transmittance of the radio-wave transparent structure 120 is greater than the preset transmittance, the display screen assembly 100 provided with the radio-wave transparent structure 120 has a relatively high transmittance, as such, there will be no great impact on the normal displaying of the display screen assembly 100.

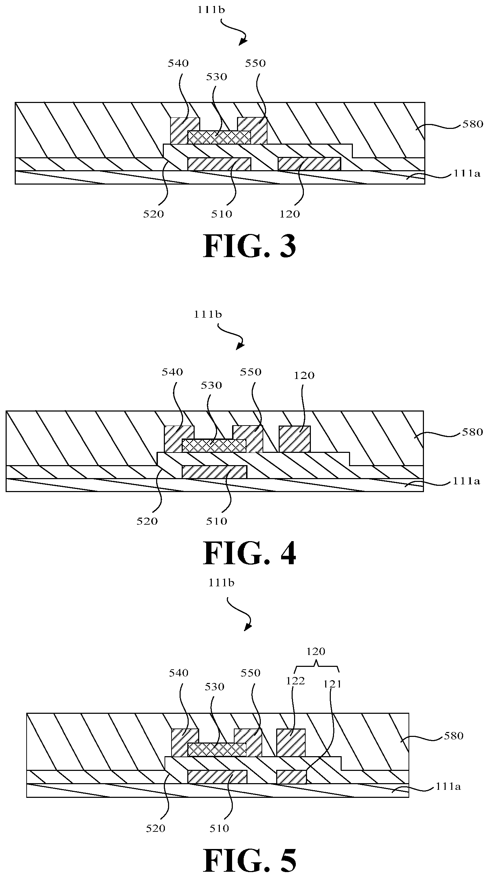

FIG. 2 is a schematic structural view of a display screen assembly provided in a second implementation of the present disclosure. FIG. 3 is a schematic cross-sectional structural view of an array substrate illustrated in FIG. 2. For ease of illustration, only one of thin film transistors 111b is illustrated. The display screen body 110 includes an array substrate 111. The array substrate 111 includes a substrate 111a and multiple thin film transistors 111b arranged in an array on the substrate 111a. The thin film transistor 111b includes a gate 510, a gate insulating layer 520, a channel layer 530, a source 540, and a drain 550. The gate 510 is disposed on one side of the substrate 111a. The gate insulating layer 520 covers the gate 510. The channel layer 530 is disposed on the gate insulating layer 520 and corresponds to the gate 510. The source 540 and the drain 550 are disposed at opposite ends of the channel layer 530 and spaced apart from each other. The source 540 and the drain 550 are both connected to the channel layer 530. The radio-wave transparent structure 120 is a single-layer structure. The radio-wave transparent structure 120 is disposed in the same layer as the gate 510.

In an implementation, the thin film transistor 111b may further include a planarization layer 580. The planarization layer 580 covers the source 540 and the drain 550.

In the display screen assembly 100 provided in the present disclosure, the radio-wave transparent structure 120 is carried on the display screen body 110. The transmittance to the RF signal in the preset frequency band is improved with aid of the radio-wave transparent structure 120. In case that the display screen assembly 100 is applied to the electronic device 1, influence of the display screen assembly 100 on the radiation performance of the antenna module disposed inside the electronic device 1 can be reduced, as such, the communication performance of the electronic device 1 can be improved. As an example, in the display screen assembly 100 provided in the present disclosure, the radio-wave transparent structure 120 is disposed in the same layer as the gate 510. As such, during preparation, the radio-wave transparent structure 120 can be prepared in the same process as the gate 510, thereby simplifying the preparation process.

FIG. 4 is a schematic cross-sectional structural view of an array substrate of a display screen assembly provided in a third implementation of the present disclosure. The display screen assembly 100 illustrated in FIG. 4 is identical to the display screen assembly 100 provided in the second implementation of the present disclosure in structure except the following. In this implementation, the radio-wave transparent structure 120 is disposed in the same layer as the source 540 and the drain 550.

In an implementation, the thin film transistor 111b may further include a planarization layer 580. The planarization layer 580 covers the source 540, the drain 550, and the radio-wave transparent structure 120.

In the display screen assembly 100 provided in the present disclosure, the radio-wave transparent structure 120 is carried on the display screen body 110. The transmittance to the RF signal in the preset frequency band is improved with aid of the radio-wave transparent structure 120. In case that the display screen assembly 100 is applied to the electronic device 1, the influence of the display screen assembly 100 on the radiation performance of the antenna module disposed inside the electronic device 1 can be reduced, as such, the communication performance of the electronic device 1 can be improved. As an example, in the display screen assembly 100 provided in the present disclosure, the radio-wave transparent structure 120 is disposed in the same layer as the gate 510. As such, during preparation, the radio-wave transparent structure 120 can be prepared in the same process as the source 540 and the drain 550, thereby simplifying the preparation process.

FIG. 5 is a schematic cross-sectional structural view of an array substrate of a display screen assembly provided in a fourth implementation of the present disclosure. The display screen body 110 includes an array substrate 111. The array substrate 111 includes a substrate 111a and multiple thin film transistors 111b arranged in an array on the substrate 111a. The thin film transistor 111b includes a gate 510, a gate insulating layer 520, a channel layer 530, a source 540, and a drain 550. The gate 510 is disposed on one side of the substrate 111a. The gate insulating layer 520 covers the gate 510. The channel layer 530 is disposed on the gate insulating layer 520 and corresponds to the gate 510. The source 540 and the drain 550 are disposed at opposite ends of the channel layer 530 and spaced apart from each other. The source 540 and the drain 550 are both connected to the channel layer 530. The radio-wave transparent structure 120 includes a first radio-wave transparent layer 121 and a second radio-wave transparent layer 122 which are stacked and spaced apart from each other. The first radio-wave transparent layer 121 is disposed in the same layer as the gate 510, and the second radio-wave transparent layer 122 is disposed in the same layer as the source 540 and the drain 550.

In the display screen assembly 100 provided in the present disclosure, the radio-wave transparent structure 120 is carried on the display screen body 110. The transmittance to the RF signal in the preset frequency band is improved with aid of the radio-wave transparent structure 120. In case that the display screen assembly 100 is applied to the electronic device 1, the influence of the display screen assembly 100 on the radiation performance of the antenna module disposed inside the electronic device 1 can be reduced, as such, the communication performance of the electronic device 1 can be improved. As an example, in the display screen assembly 100 provided in the present disclosure, the radio-wave transparent structure 120 is disposed in the same layer as the gate 510. As such, during preparation, the first radio-wave transparent layer 121 can be prepared in the same process as the gate 510, and the second radio-wave transparent layer 122 can be prepared in the same process as the source 540 and the drain 550, thereby simplifying the preparation process.

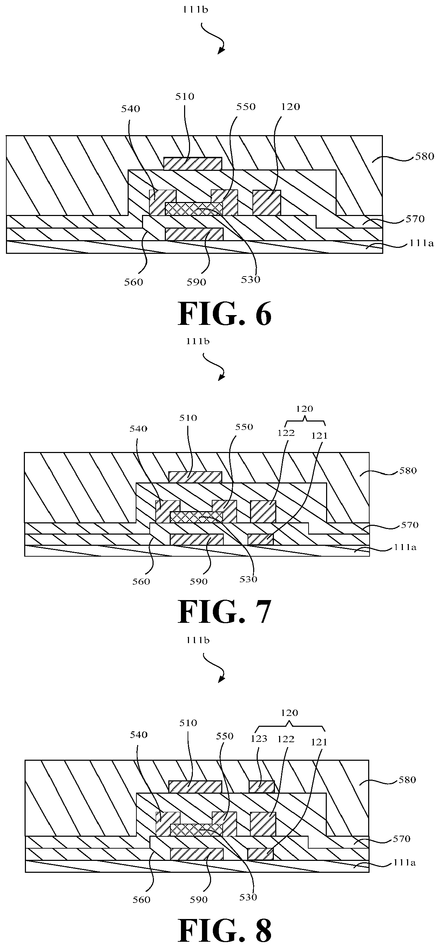

FIG. 6 is a schematic cross-sectional structural view of an array substrate of a display screen assembly provided in a fifth implementation of the present disclosure. The display screen body 110 includes an array substrate 111. The array substrate 111 includes a substrate 111a and multiple thin film transistors 111b arranged in an array on the substrate 111a. The thin film transistor 111b includes a light-shielding layer 590, a first insulating layer 560, a channel layer 530, a source 540, a drain 550, a second insulating layer 570, a gate 510, and a planarization layer 580. The light-shielding layer 590 is disposed on one side of the substrate 111a. The first insulating layer 560 covers the light-shielding layer 590. The channel layer 530 is disposed on the first insulating layer 560 and corresponds to the light-shielding layer 590. The source 540 and the drain 550 are disposed at opposite ends of the channel layer 530 and spaced apart from each other. The source 540 and the drain 550 are both connected to the channel layer 530. The second insulating layer 570 covers the source 540 and the drain 550. The gate 510 is disposed on the second insulating layer 570. The radio-wave transparent structure 120 is a single-layer structure. The radio-wave transparent structure 120 is disposed in the same layer as the light-shielding layer 590. It is noted that, in other implementations, the radio-wave transparent structure 120 can be disposed in the same layer as the gate 510. Alternatively in other implementations, the radio-wave transparent structure 120 is disposed in the same layer as the source 540 and the drain 550. In an example, the thin film transistor 111b further includes the planarization layer 580. The planarization layer 580 covers the gate 510. As illustrated, the radio-wave transparent structure 120 is disposed in the same layer as the source 540 and the drain 550.

In the display screen assembly 100 provided in the present disclosure, the radio-wave transparent structure 120 is carried on the display screen body 110. The transmittance to the RF signal in the preset frequency band is improved with aid of the radio-wave transparent structure 120. In case that the display screen assembly 100 is applied to the electronic device 1, the influence of the display screen assembly 100 on the radiation performance of the antenna module disposed inside the electronic device 1 can be reduced, as such, the communication performance of the electronic device 1 can be improved. The radio-wave transparent structure 120 is disposed in the same layer as the gate 510. Alternatively, the radio-wave transparent structure 120 is disposed in the same layer as the source 540 and the drain 550. As such, the preparation process can be simplified.

FIG. 7 is a schematic cross-sectional structural view of the array substrate of the display screen assembly provided in the fifth implementation of the present disclosure. The display screen body 110 includes an array substrate 111. The array substrate 111 includes a substrate 111a and multiple thin film transistors 111b arranged in an array on the substrate 111a. The thin film transistor 111b includes a light-shielding layer 590, a first insulating layer 560, a channel layer 530, a source 540, a drain 550, a second insulating layer 570, a gate 510, and a planarization layer 580. The light-shielding layer 590 is disposed on one side of the substrate 111a. The first insulating layer 560 covers the light-shielding layer 590. The channel layer 530 is disposed on the first insulating layer 560 and corresponds to the light-shielding layer 590. The source 540 and the drain 550 are disposed at opposite ends of the channel layer 530 and spaced apart from each other. The source 540 and the drain 550 are both connected to the channel layer 530. The second insulating layer 570 covers the source 540 and the drain 550. The gate 510 is disposed on the second insulating layer 570. The radio-wave transparent structure 120 includes a first radio-wave transparent layer 121 and a second radio-wave transparent layer 122 which are stacked and spaced apart from each other. The first radio-wave transparent layer 121 is disposed in the same layer as one of the light-shielding layer 590, the gate 510, and the source 540, and the second radio-wave transparent layer 122 is disposed in the same layer as another one of the light-shielding layer 590, the gate 510, and the source 540. In a non-limiting example, as illustrated in FIG. 7, the first radio-wave transparent layer 121 is disposed in the same layer as the light-shielding layer 590, and the second radio-wave transparent layer 122 is disposed in the same layer as the source 540 and the drain 550.

In the display screen assembly 100 provided in the present disclosure, the radio-wave transparent structure 120 is carried on the display screen body 110. The transmittance to the RF signal in the preset frequency band is improved with aid of the radio-wave transparent structure 120. In case that the display screen assembly 100 is applied to the electronic device 1, the influence of the display screen assembly 100 on the radiation performance of the antenna module disposed inside the electronic device 1 can be reduced, as such, the communication performance of the electronic device 1 can be improved. Further, the first radio-wave transparent layer 121 is disposed in the same layer as one of the light-shielding layer 590, the gate 510, and the source 540, and the second radio-wave transparent layer 122 is disposed in the same layer as another one of the light-shielding layer 590, the gate 510, which can simplify the preparation process.

In other implementations, when the radio-wave transparent structure 120 includes the first radio-wave transparent layer 121 and the second radio-wave transparent layer 122 spaced apart from each other, the first radio-wave transparent layer 121 can serve as the light-shielding layer 590 of the display screen assembly 100. The light-shielding layer 590 is used to prevent the thin film transistor 111b from malfunction caused by light incident into the channel layer 530 from one surface of the substrate 111a away from the light-shielding layer 590.

FIG. 8 is a schematic cross-sectional structural view of an array substrate of a display screen assembly provided in a sixth implementation of the present disclosure. The display screen body 110 includes an array substrate 111. The array substrate 111 includes a substrate 111a and multiple thin film transistors 111b arranged in an array on the substrate 111a. The thin film transistor 111b includes a light-shielding layer 590, a first insulating layer 560, a channel layer 530, a source 540, a drain 550, a second insulating layer 570, a gate 510, and a planarization layer 580. The light-shielding layer 590 is disposed on one side of the substrate 111a. The first insulating layer 560 covers the light-shielding layer 590. The channel layer 530 is disposed on the first insulating layer 560 and corresponds to the light-shielding layer 590. The source 540 and the drain 550 are disposed at opposite ends of the channel layer 530 and spaced apart from each other. The source 540 and the drain 550 are both connected to the channel layer 530. The second insulating layer 570 covers the source 540 and the drain 550. The gate 510 is disposed on the second insulating layer 570. The radio-wave transparent structure 120 includes a first radio-wave transparent layer 121, a second radio-wave transparent layer 122, and a third radio-wave transparent layer 123 which are stacked and spaced apart from one another. The first radio-wave transparent layer 120 is disposed in the same layer as the light-shielding layer 590. The second radio-wave transparent layer 122 is disposed in the same layer as the source 540 and the drain 550. The third radio-wave transparent layer 123 is disposed in the same layer as the gate 510.

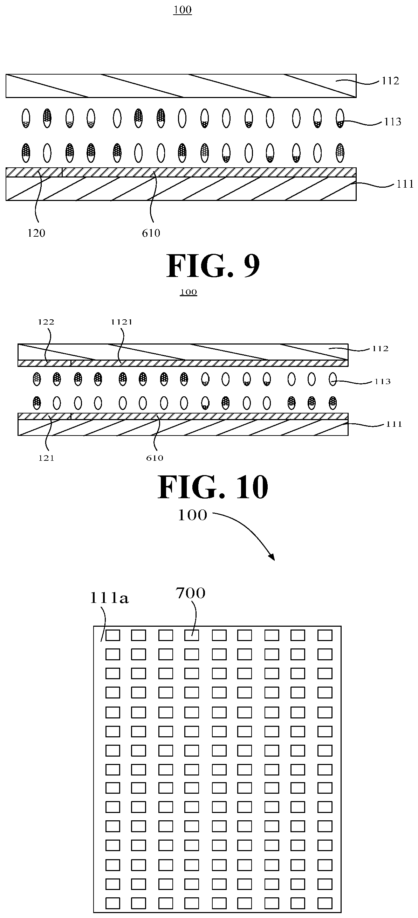

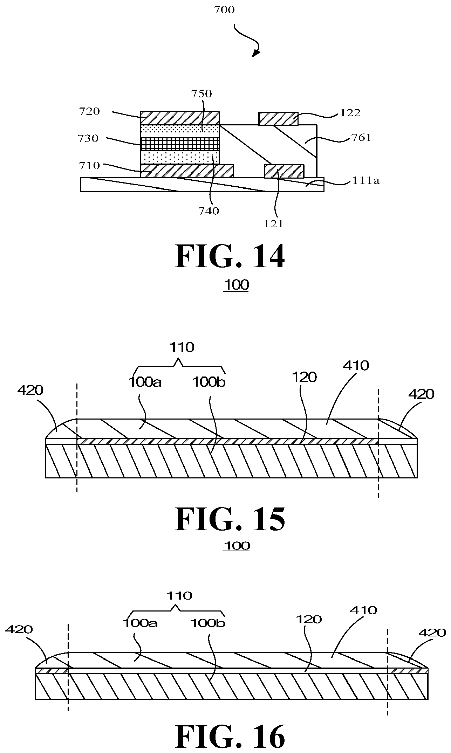

FIG. 9 is a schematic structural view of a display screen assembly provided in a seventh implementation of the present disclosure. The display screen assembly 100 includes an array substrate 111, a color filter substrate 112, and a liquid crystal layer 113. The array substrate 111 is opposite to and spaced apart from the color filter substrate 112. The liquid crystal layer 113 is disposed between the array substrate 111 and the color filter substrate 112. The array substrate 111 includes a pixel electrode 610. The pixel electrode 610 is a semiconductor made of a transparent metal oxide material. The radio-wave transparent structure 120 is at least partially disposed in the same layer as the pixel electrode 610 and made of the same material as the pixel electrode 610. The pixel electrode 610 is electrically connected to the drain 550 in the thin film transistor 111b. The pixel electrode 610 can be incorporated into the thin film transistor 111b described in any of the foregoing implementations. FIG. 14 illustrates an example that the pixel electrode 610 is incorporated into one of the thin film transistors 111b described above.

FIG. 10 is a schematic structural view of a display screen assembly provided in an eighth implementation of the present disclosure. The display panel includes an array substrate 111 and a color filter substrate 112 which are arranged opposite to and spaced apart from each other. The radio-wave transparent structure 120 includes a first radio-wave transparent layer 121 and a second radio-wave transparent layer 122. The first radio-wave transparent layer 121 is disposed on the array substrate 111. The second radio-wave transparent layer 122 is disposed on the color filter substrate 112. In an example, the display screen assembly 100 further includes a liquid crystal layer 113. The array substrate 111 is opposite to and spaced apart from the color filter substrate 112. The liquid crystal layer 113 is disposed between the array substrate 111 and the color filter substrate 112.

In an implementation, the color filter substrate 112 may include a pixel electrode 610. The array substrate 111 may include a common electrode 1121. The first radio-wave transparent layer 121 is disposed in the same layer as the pixel electrode 610. The second radio-wave transparent layer 122 is disposed in the same layer as the common electrode 1121. The pixel electrode 610 and the common electrode 1121 cooperate to control the orientation of the liquid crystal molecules in the liquid crystal layer 113.

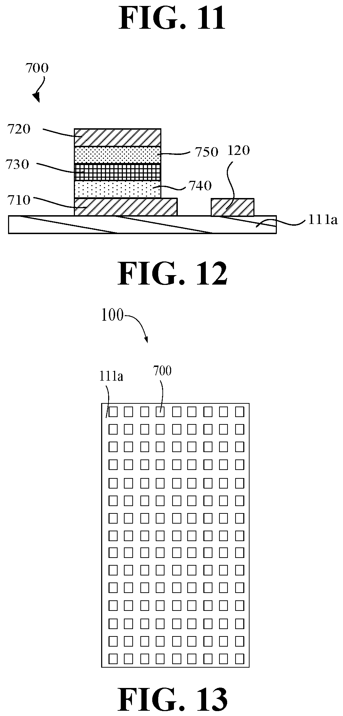

FIG. 11 is a schematic structural view of a display screen assembly provided in a ninth implementation of the present disclosure. FIG. 12 is a schematic cross-sectional structural view of the display screen assembly illustrated in FIG. 11. The display screen body 110 includes a substrate 111a and light-emitting elements 700 arranged in an array on the substrate 111a. The light-emitting element 700 includes a first electrode 710, a light-emitting layer 730, and a second electrode 720. The first electrode 710 is disposed more adjacent to the substrate 111a than the light-emitting layer 730 and the second electrode 720. The light-emitting layer 730 is disposed on one side of the first electrode 710 away from the substrate 111a. The second electrode 720 is disposed on one side of the light-emitting layer 730 away from the first electrode 710. The first electrode 710 is configured to load a first voltage. The second electrode 720 is configured to load a second voltage. The light-emitting layer 730 is configured to emit light under action of the first voltage and the second voltage. The radio-wave transparent structure 120 is a single-layer structure. The radio-wave transparent structure 120 is disposed in the same layer as the first electrode 710 or the second electrode 720. As a non-limiting example, referring to FIG. 12, the radio-wave transparent structure 120 is disposed in the same layer as the first electrode 710.

The operating principle of the light-emitting element 700 is introduced below. In an implementation, the first electrode 710 is an anode and the second electrode 720 is a cathode. In this case, the first electrode 710 is used to generate electron holes, the second electrode 720 is used to generate electrons. The electrons generated by the second electrode 720 and the electron holes generated by the first electrode 710 can be combined in the light-emitting layer 730 to generate light. In another implementation, the first electrode 710 can be a cathode, and the second electrode 720 can be an anode. As an example, the light-emitting element 700 can further include a hole injection-and-transport layer 740 and an electron injection-and-transport layer 750. When the first electrode 710 is the anode and the second electrode 720 is the cathode, the hole injection-and-transport layer 740 is disposed between the first electrode 710 and the light-emitting layer 730 to transport the electron holes generated by the first electrode 710 to the light-emitting layer 730. The electron injection-and-transport layer 750 is disposed between the second electrode 720 and the light-emitting layer 730 to transport the electrons generated by the second electrode 720 to the light-emitting layer 730.

FIG. 13 is a schematic structural view of a display screen assembly provided in a tenth implementation of the present disclosure. FIG. 14 is a schematic cross-sectional structural view of the display screen assembly illustrated in FIG. 13. The display screen body 110 includes a substrate 111a and light-emitting elements 700 arranged in an array on the substrate 111a. The light-emitting element 700 includes a first electrode 710, a light-emitting layer 730, and a second electrode 720. The first electrode 710 is disposed more adjacent to the substrate 111a than the light-emitting layer 730 and the second electrode 720. The light-emitting layer 730 is disposed on one side of the first electrode 710 away from the substrate 111a. The second electrode 720 is disposed on one side of the light-emitting layer 730 away from the first electrode 710. The first electrode 710 is configured to load a first voltage. The second electrode 720 is configured to load a second voltage. The light-emitting layer 730 is configured to emit light under action of the first voltage and the second voltage. The radio-wave transparent structure 120 includes a first radio-wave transparent layer 121 and a second radio-wave transparent layer 122. The first radio-wave transparent layer 121 is disposed in the same layer as the first electrode 710. The second radio-wave transparent layer 122 is disposed in the same layer as the second electrode 720.

In an implementation, the first electrode 710 can be an anode and the second electrode 720 can be a cathode. In another implementation, the first electrode 710 is the cathode and the second electrode 720 is the anode. As an example, the light-emitting element 700 can further include a hole injection-and-transport layer 740 and an electron injection-and-transport layer 750. When the first electrode 710 is the anode and the second electrode 720 is the cathode, the hole injection-and-transport layer 740 is disposed between the first electrode 710 and the light-emitting layer 730 to transport the electron holes generated by the first electrode 710 to the light-emitting layer 730. The electron injection-and-transport layer 750 is disposed between the second electrode 720 and the light-emitting layer 730 to transport the electrons generated by the second electrode 720 to the light-emitting layer 730. It is noted that, an insulating layer 761 can be disposed between the first radio-wave transparent 121 and the second radio-wave transparent 122.

FIG. 15 is a schematic structural view of a display screen assembly provided in an eleventh implementation of the present disclosure. The display screen body 110 can include a screen body 410 and an extending portion 420 bent and extended from a periphery of the screen body 410. The radio-wave transparent structure 120 is disposed corresponding to the screen body 410. In this implementation, as a non-limiting example, the display screen body 110 includes a display screen 100a and a cover plate 100b stacked with the display screen 100a, and the radio-wave transparent structure 120 is disposed on the surface of the cover plate 100b facing the display screen 100a.

FIG. 16 is a schematic structural view of a display screen assembly provided in a twelfth implementation of the present disclosure. The display screen assembly 100 in this implementation is identical to the display screen assembly 100 provided in the eleventh implementation of the present disclosure in structure, except that the radio-wave transparent structure 120 is disposed corresponding to the extending portion 420.

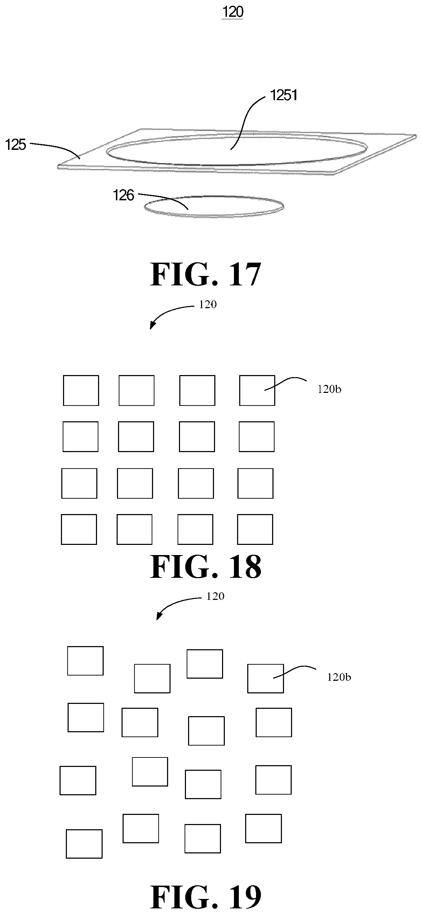

FIG. 17 is a schematic view of a radio-wave transparent structure provided in the first implementation of the present disclosure. In this implementation, the first radio-wave transparent structure 120 includes the first radio-wave transparent 121 and the second radio-wave transparent 122, and the first radio-wave transparent 121 is spaced apart from and coupled with the second radio-wave transparent 122. The first radio-wave transparent structure 125 defines a through hole 1251, and an orthographic projection of the second radio-wave transparent structure 126 on the first radio-wave transparent structure 125 falls within the through hole 1251.

It is noted that, in case that the radio-wave transparent structure 120 includes the first radio-wave transparent 121 and the second radio-wave transparent 122 spaced apart from each other, the first radio-wave transparent 121 and the second radio-wave transparent 122 are operable to be coupled with each other. As such, the display screen assembly 100 has a greater transmittance to the RF signal in the preset frequency band in the region corresponding to the radio-wave transparent structure 120 than a display screen assembly without the radio-wave transparent structure 120.

FIG. 18 is a schematic structural view of a radio-wave transparent structure provided in the second implementation of the present disclosure. The radio-wave transparent structure 120 can be applied to the display screen assembly 100 provided in any of the foregoing implementations. The radio-wave transparent structure 120 includes multiple resonant elements 120b, and the resonant elements 120b are arranged at regular intervals.

FIG. 19 is a schematic structural view of a radio-wave transparent structure provided in the third implementation of the present disclosure. The radio-wave transparent structure 120 can be applied to the display screen assembly 100 provided in any of the foregoing implementations. The radio-wave transparent structure 120 includes multiple resonant elements 120b, and the resonant elements 120b are arranged at irregular intervals.

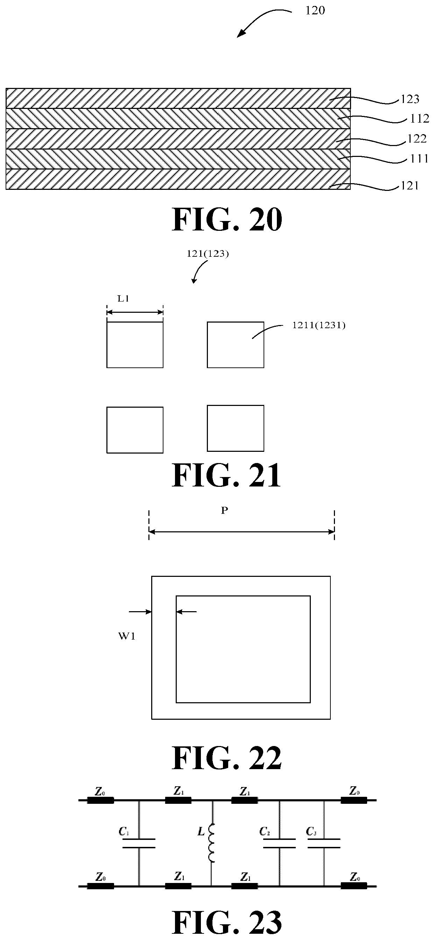

FIG. 20 is a schematic cross-sectional structural view of a radio-wave transparent structure provided in the fourth implementation of the present disclosure. FIG. 21 is a schematic structural view of a first radio-wave transparent layer of the radio-wave transparent structure provided in the fourth implementation of the present disclosure. FIG. 22 is a schematic structural view of a second radio-wave transparent layer of the radio-wave transparent structure provided in the fourth implementation of the present disclosure. The radio-wave transparent structure 120 can be applied to the display screen assembly provided in any of the foregoing implementations. The radio-wave transparent structure 120 includes the first radio-wave transparent layer 121, the second radio-wave transparent layer 122, and the third radio-wave transparent layer 123 spaced apart from each other. A first dielectric layer 111 can be disposed between the first radio-wave transparent layer 121 and the second radio-wave transparent layer 122. A second dielectric layer 111 can be disposed between the second radio-wave transparent layer 122 and the third radio-wave transparent layer 123. The first radio-wave transparent layer 121, the first dielectric layer 111, the second radio-wave transparent layer 122, the second dielectric layer 112, and the third radio-wave transparent layer 123 are stacked in sequence. The first radio-wave transparent layer 121 may include multiple first patches 1211 arranged in an array. The second radio-wave transparent layer 122 may include multiple mesh-grid structures 1221 arranged at regular intervals. The third radio-wave transparent layer 123 may include multiple second patches 1231 arranged in an array. The smaller a size *L1* of the first patch 1211 or the second patch 1231, the more the preset frequency band shifts towards a low frequency side and the narrower a bandwidth of the preset frequency band. The smaller a width *W1* of the mesh-grid structure 1221 of the second radio-wave transparent layer 122, the more the preset frequency band shifts towards the low frequency side and the wider the bandwidth of the preset frequency band. The larger a period P of the radio-wave transparent structure 120, the more the preset frequency band shifts towards a high frequency side and the wider the bandwidth of the preset frequency band. The thicker the radio-wave transparent structure 120, the more the preset frequency band shifts towards the low frequency side and the narrower the bandwidth of the preset frequency band. The greater a dielectric constant of the dielectric substrate 110, the more the preset frequency band shifts towards the low frequency side and the narrower the bandwidth of the preset frequency band. In this implementation, one mesh-grid structure 1221 corresponds to four first patches 1211 and four third patches 1231, and serves as one period of the radio-wave transparent structure 120.

FIG. 23 is an equivalent circuit diagram of the radio-wave transparent structure provided in the fourth implementation of the present disclosure. In this equivalent circuit diagram, factors that have little influences on the preset frequency band are ignored, such as an inductance of the first radio-wave transparent layer 121, an inductance of the third radio-wave transparent layer 123, and a capacitance of the second radio-wave transparent layer 122. The first radio-wave transparent layer 121 is equivalent to Capacitor C1, the second radio-wave transparent layer 122 is equivalent to Capacitor C2, a coupling capacitance between the first radio-wave transparent layer 121 and the second radio-wave transparent layer 122 is equivalent to Capacitor C3, and the third radio-wave transparent layer 123 is equivalent to Inductance L. In addition, Z*0* represents an impedance of the free space, *Z1* represents an impedance of the dielectric substrate 110, and *Z1* = *Z0*/(*Dk*)^{1/2}*.* The preset frequency band has a center frequency *f0,* and *f0* = 1/[2 π /(*LC*)^{1/2}]*.* A ratio of a bandwidth *Δf* to the center frequency *f0* is proportional to (*L*/*C*)^{1/2}*.* It can be seen that, as the size of the first patch 1211 or the second patch 1231 decreases, the preset frequency band shifts towards the low frequency side and a bandwidth of the preset frequency band decreases. As the width of the mesh-grid structure 1221 of the second radio-wave transparent layer 122 decreases, the preset frequency band shifts towards the low frequency side and the bandwidth of the preset frequency band increases. As the period of the radio-wave transparent layers 120a increases, the preset frequency band shifts towards the high frequency side and the bandwidth of the preset frequency band increases. As the thickness of the radio-wave transparent layers 120a increases, the preset frequency band shifts towards the low frequency side and the bandwidth of the preset frequency band decreases. As the dielectric constant of the dielectric substrate 110 increases, the preset frequency band shifts towards the low frequency side and the bandwidth of the preset frequency band decreases.

In an implementation, the first dielectric layer 111 and the second dielectric layer 112 are made of glass which generally has a dielectric constant falling within a range from 6 to 7.6. When the preset frequency band is in a range of 20 GHz to 35 GHz, the first patch 1211 generally has a size falling within a range from 0.5 mm to 0.8 mm. A solid part of the mesh-grid structure of the second radio-wave transparent layer 128 generally has a width falling within a range from 0.1 mm to 0.5 mm. One period generally has a length falling within a range from 1.5 mm to 3 mm. When the radio-wave transparent structure 120 is applied to the display screen assembly of the electronic device, a distance between an upper surface of the antenna module 200 and an inner surface of the display screen assembly is generally greater than or equal to zero, and in an implementation, the distance is generally from 0.5 mm to 1.2 mm.

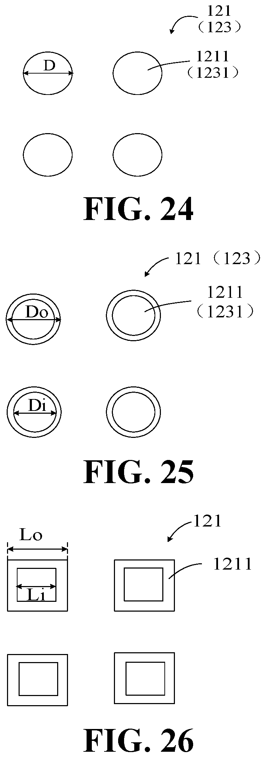

FIG. 24 is a schematic view of the first radio-wave transparent layer of the radio-wave transparent structure provided in a fifth implementation of the present disclosure. The radio-wave transparent structure 120 in this implementation is substantially identical to the radio-wave transparent structure 120 in the fourth implementation except the following. Each first patch 1211 in the fourth implementation is rectangular, while the first radio-wave transparent layer 121 in this implementation includes multiple first patches 1211 arranged in an array, and each first patch 1211 in this implementation is in a circular shape. In an implementation, each first patch 1211 has a diameter D falling within a range from 0.5 mm to 0.8 mm.

In this implementation, the third radio-wave transparent layer 123 can include multiple second patches 1231 arranged in an array, and each second patch 1231 can be in a circular shape. In an example, each second patch 1231 may have a diameter D falling within a range from 0.5 mm to 0.8 mm. It is noted that, the third radio-wave transparent layer 123 may be identical to the first radio-wave transparent layer 121 in structure.

FIG. 25 is a schematic structural view of the first radio-wave transparent layer of the radio-wave transparent structure provided in a sixth implementation of the present disclosure. The radio-wave transparent structure 120 in this implementation is substantially identical to the radio-wave transparent structure 120 in the fourth implementation except the following. Each first patch 1211 in the fourth implementation is rectangular, while the first radio-wave transparent layer 121 in this implementation includes multiple first patches 1211 arranged in an array, and each first patch 1211 in this implementation is in a ring shape. When the first patch 1211 is made of metal, the first patch 1211 being in the ring shape can improve a light transmittance of the radio-wave transparent structure 120. In an implementation, each first patch 1211 in the ring shape may have an outer diameter Do falling within a range from 0.5 mm to 0.8 mm and an inner diameter Di. Generally, the smaller a difference between the outer diameter Do and the inner diameter Di (i.e., Do-Di), the greater the light transmittance of the radio-wave transparent structure 120, and the greater an insertion loss. In order to balance the light transmittance and the insertion loss of the radio-wave transparent structure 120, a value of Do-Di is generally greater than or equal to 0.5 mm. It is noted that, the third radio-wave transparent layer 123 may be identical to the first radio-wave transparent layer 121 in structure.

FIG. 26 is a schematic structural view of the first radio-wave transparent layer of the radio-wave transparent structure provided in a seventh implementation of the present disclosure. The radio-wave transparent structure 120 in this implementation is substantially identical to the radio-wave transparent structure 120 in the fourth implementation except the following. Each first patch 1211 in the fourth implementation is rectangular, while the first radio-wave transparent layer 121 in this implementation includes multiple first patches 1211 arranged in an array, and each first patch 1211 in this implementation is in a square ring shape. In an implementation, each first patch 1211 generally has an outer side length Lo falling within a range from 0.5 mm to 0.8 mm, and an inner side length Li. Generally, the smaller a value of Lo-Li (i.e., a difference between the outer side length Lo and the inner side length Li), the greater the light transmittance, and the greater the insertion loss. In order to balance the light transmittance and the insertion loss of the radio-wave transparent structure 120, the value of Lo-Li is generally greater than or equal to 0.5 mm. It is noted that, the third radio-wave transparent layer 123 may be identical to the first radio-wave transparent layer 121 in structure.

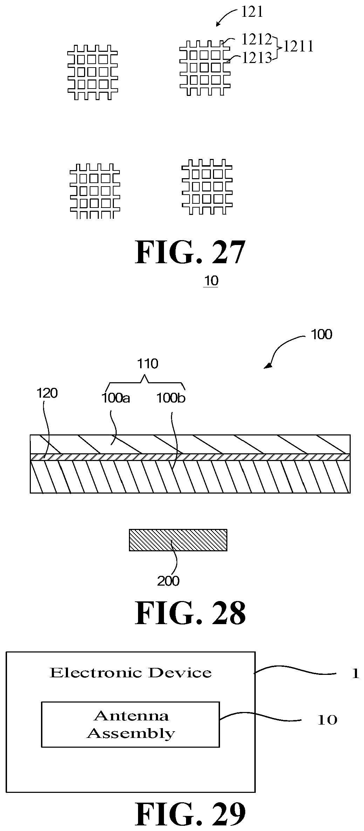

FIG. 27 is a schematic structural view of the first radio-wave transparent layer of the radio-wave transparent structure provided in an eighth implementation of the present disclosure. The radio-wave transparent structure 120 in this implementation includes multiple first patches 1211 arranged in an array, and each first patch 1211 is a metal mesh-grid patch in a square shape. In an implementation, the first patch 1211 includes multiple first branches 1212 and multiple second branches 1213. The multiple first branches 1212 are spaced apart from each other, the multiple second branches 1213 are spaced apart from each other, and the multiple second branches 1213 and the multiple first branches 1212 are intersected and connected. In an implementation, the multiple first branches 1212 may extend along a first direction and be spaced apart from each other along a second direction. In an implementation, the multiple second branches 1213 may intersect and be perpendicular to the multiple first branches 1212. In an implementation, each first branch 1212 may have a side length falling within a range from 0.5 mm to 0.8 mm.

FIG. 28 is a schematic structural view of an antenna assembly provided in the present disclosure. The antenna assembly 10 includes an antenna module 200 and the display screen assembly 100 provided in any of the forgoing implementations. The antenna module 200 is configured to emit and receive, within a preset range, the RF signal in the preset frequency band. The radio-wave transparent structure 120 in the display screen assembly 100 is at least partially located within the preset range. The display screen assembly 100 provided in the first implementation of the present disclosure can be taken as an example of the display screen assembly 100 of the antenna assembly 10 in this implementation for illustration.

FIG. 29 is a schematic structural view of an electronic device provided in the first implementation of the present disclosure. The electronic device includes an antenna assembly 10. As for the antenna assembly 10, reference can be made to the forgoing implementations, which will not be repeated herein.

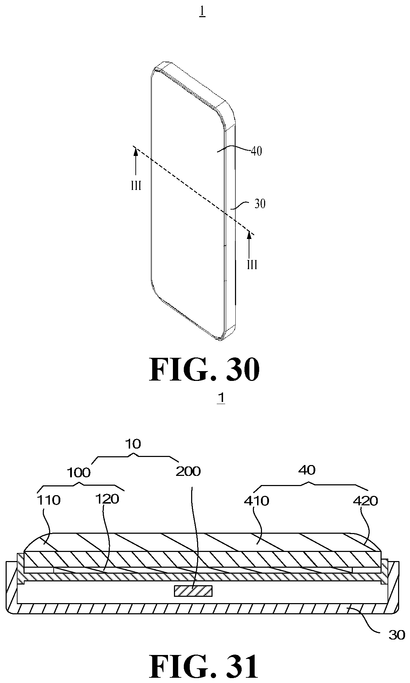

FIG. 30 is a schematic structural view of an electronic device provided in the second implementation of the present disclosure. FIG. 31 is a schematic cross-sectional structural view along line III-III of FIG. 30. The electronic device 1 includes an antenna assembly 10. As for the antenna assembly 10, reference can be made to the forgoing implementations, which will not be repeated herein. The display screen body 110 can include a screen body 410 and an extending portion 420 bent and extended from a periphery of the screen body 410. The radio-wave transparent structure 120 is disposed corresponding to the screen body 410.

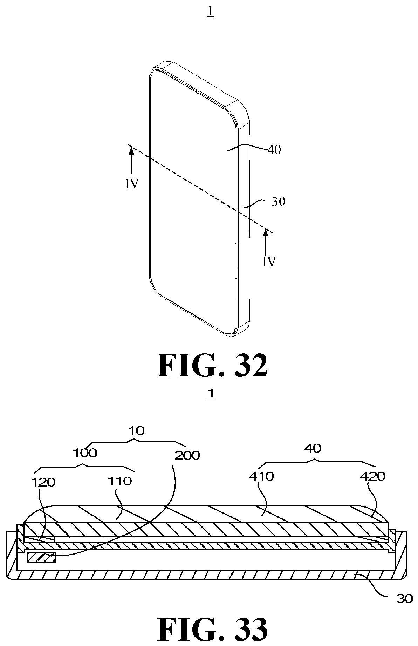

FIG. 32 is a schematic structural view of an electronic device provided in the third implementation of the present disclosure. FIG. 33 is a schematic cross-sectional structural view along line IV-IV of FIG. 32. The electronic device 1 includes an antenna assembly 10. As for the antenna assembly 10, reference can be made to the forgoing implementations, which will not be repeated herein. The display screen body 110 can include a screen body 410 and an extending portion 420 bent and extended from a periphery of the screen body 410. The radio-wave transparent structure 120 is disposed corresponding to the extending portion 420.

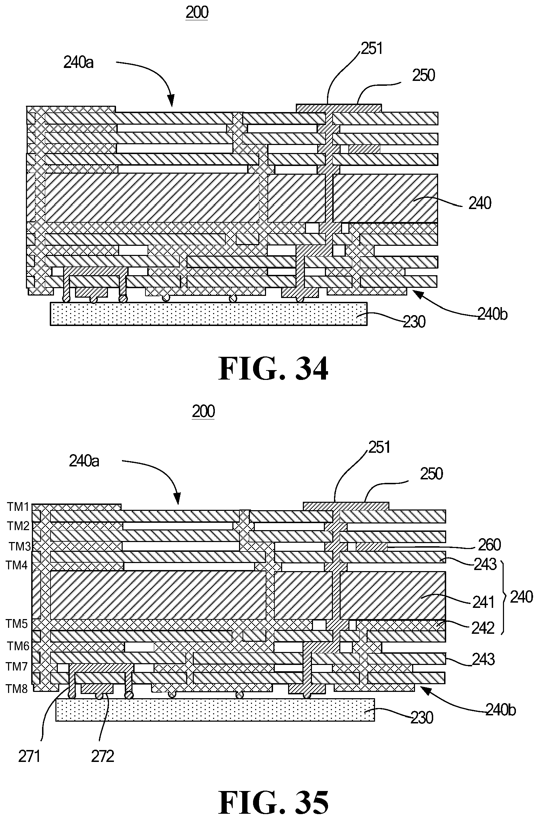

FIG. 34 is a schematic cross-sectional structural view of the antenna module 200 provided in an implementation of the present disclosure. The antenna module 200 can include an RF chip 230, an insulating substrate 240, and at least one first antenna radiator 250. The RF chip 230 is configured to generate an excitation signal (also referred to as an RF signal). The RF chip 230 is further away from the radio-wave transparent structure 120 than the at least one first antenna radiator 250. The insulating substrate 240 is configured to carry the at least one first antenna radiator 250. The RF chip 230 is electrically coupled with the at least one first antenna radiator 250 via transmission lines embedded in the insulating substrate 240. In an implementation, the insulating substrate 240 includes a first surface 240a and a second surface 240b opposite to the first surface 240a. In the implementation, the at least one first antenna radiator 250 is disposed on the first surface 240a. Alternatively, the at least one first antenna radiator 250 is embedded in the insulating substrate 240. Referring to FIG. 34, an example that the at least one first antenna radiator 250 is disposed on the first surface 240a and the RF chip 230 is disposed on the second surface 240b is given for illustration. The excitation signal generated by the RF chip 230 is transmitted to the at least one first antenna radiator 250 via the transmission lines embedded in the insulating substrate 240. The RF chip 230 may be soldered on the insulating substrate 240 such that the excitation signal is transmitted to the first antenna radiator 250 via the transmission lines embedded in the insulating substrate 240. The first antenna radiator 250 receives the excitation signal and generates a millimeter wave signal according to the excitation signal. Each first antenna radiator 250 may be but is not limited to a patch antenna.

In an example, the RF chip 230 is further away from the radio-wave transparent structure 120 than the first antenna radiator 250. An output terminal of the RF chip 230 used to output the excitation signal is disposed at a side of the insulating substrate 240 away from the radio-wave transparent structure 120. That is, the RF chip 230 is disposed close to the second surface 240b of the insulating substrate 240 and away from the first surface 240a of the insulating substrate 240.

In an example, each first antenna radiator 250 includes at least one feeding point 251. Each feeding point 251 is electrically coupled with the RF chip 230 via the transmission lines. A distance between each feeding point 251 and a center of the first antenna radiator 250 corresponding to the feeding point 251 is greater than a preset distance. An adjustment of a position of the feeding point 251 can change an input impedance of the first antenna radiator 250. In this implementation, by setting the distance between each feeding point 251 and the center of the first antenna radiator 250 corresponding to the feeding point 251 to be greater than the preset distance, the input impedance of the first antenna radiator 250 may be adjusted. The input impedance of the first antenna radiator 250 is adjusted to enable the input impedance of the first antenna radiator 250 to match an output impedance of the RF chip 230. When the input impedance of the first antenna radiator 250 matches the output impedance of the RF chip 230, a reflection amount of the excitation signal generated by the RF signal is minimal.

FIG. 35 is a schematic cross-sectional view of the antenna module provided in another implementation of the present disclosure. The antenna module 200 provided in this implementation is substantially identical to the antenna module 200 provided in the first implementation except the following. The antenna module 200 in this implementation further includes a second antenna radiator 260. That is, in this implementation, the antenna module 200 can include the RF chip 230, the insulating substrate 240, the at least one first antenna radiator 250, and the second antenna radiator 260. The RF chip 230 is configured to generate an excitation signal. The insulating substrate 240 includes the first surface 240a and the second surface 240b opposite to the first surface 240a. The at least one first antenna radiator 250 is disposed on the first surface 240a, and the RF chip 230 is disposed on the second surface 240b. The excitation signal generated by the RF chip 230 is transmitted to the at least one first antenna radiator 250 via the transmission lines embedded in the insulating substrate 240. The RF chip 230 can be soldered on the insulating substrate 240 such that the excitation signal is transmitted to the first antenna radiator 250 via the transmission lines embedded in the insulating substrate 240. The first antenna radiator 250 receives the excitation signal and generates a millimeter wave signal according to the excitation signal.

In an example, the RF chip 230 is further away from the radio-wave transparent structure 120 than the first antenna radiator 250. The output terminal of the RF chip 230 used to output the excitation signal is disposed at the side of the insulating substrate 240 away from the radio-wave transparent structure 120.

In an example, each first antenna radiator 250 includes at least one feeding point 251. Each feeding point 251 is electrically coupled with the RF chip 230 via the transmission lines. A distance between each feeding point 251 and the center of the first antenna radiator 250 corresponding to the feeding point 251 is smaller than the preset distance.

In this implementation, the second antenna radiator 260 is embedded in the insulating substrate 240. The second antenna radiator 260 is spaced apart from the first antenna radiator 250, and the second antenna radiator 260 is coupled with the first antenna radiator 250 to form a stacked patch antenna. When the second antenna radiator 260 is coupled with the first antenna radiator 250 to form the stacked patch antenna, the first antenna radiator 250 is electrically connected with the RF chip 230, while the second antenna radiator 260 is not electrically connected with the RF chip 230. The second antenna radiator 260 couples with the millimeter wave signal radiated by the first antenna radiator 250 and generates a new millimeter wave signal according to the millimeter wave signal radiated by the first antenna radiator 250 coupled with the second antenna radiator 260.

Further, an example that the antenna module 200 is manufactured through HDI process is given below for illustration. The insulating substrate 240 includes a core layer 241 and multiple wiring layers 242 stacked on opposite sides of the core layer 241. The core layer 241 is an insulating layer, and an insulating layer 243 is generally sandwiched between each two adjacent wiring layers 242. The wiring layer 242 disposed at a side of the core layer 241 close to the radio-wave transparent structure 120 and furthest away from the core layer 241 has an outer surface forming the first surface 240a of the insulating substrate 240. The wiring layer 242 disposed at a side of the core layer 241 away from the radio-wave transparent structure 120 and furthest away from the core layer 241 has an outer surface forming the second surface 240b of the insulating substrate 240. The first antenna radiator 250 is disposed on the first surface 240a. The second antenna radiator 260 is embedded in the insulating substrate 240. That is, the second antenna radiator 260 can be disposed on other wiring layers 122 which are used for arranging antenna radiators, and the second antenna radiator 260 is not disposed on a surface of the insulating substrate 240.

In this implementation, an example that the insulating substrate 240 is of an eight-layer structure is given below for illustration. It is noted that, in other implementations, other number of layers of the insulating substrate 240 may be adopted. The insulating substrate 240 includes the core layer 241, a first wiring layer TM1, a second wiring layer TM2, a third wiring layer TM3, a fourth wiring layer TM4, a fifth wiring layer TM5, a sixth wiring layer TM6, a seventh wiring layer TM7, and an eighth wiring layer TM8. The first wiring layer TM1, the second wiring layer TM2, the third wiring layer TM3, and the fourth wiring layer TM4 are sequentially stacked on a surface of the core layer 241. The first wiring layer TM1 is disposed further away from the core layer 241 than the fourth wiring layer TM4. A surface of the first wiring layer TM1 away from the core layer 241 is the first surface 240a of the insulating substrate 240. The fifth wiring layer TM5, the sixth wiring layer TM6, the seventh wiring layer TM7, and the eighth wiring layer TM8 are sequentially stacked on another same surface of the core layer 241. The eighth wiring layer TM8 is disposed further away from the core layer 241 than the fifth wiring layer TM5. A surface of the eighth wiring layer TM8 away from the core layer 241 is the second surface 240b of the insulating substrate 240. Normally, the first wiring layer TM1, the second wiring layer TM2, the third wiring layer TM3, and the fourth wiring layer TM4 form wiring layers 122 that can be provided with the antenna radiators. The fifth wiring layer TM5 is a ground layer on which a ground electrode is provided. The sixth wiring layer TM6, the seventh wiring layer TM7, and the eighth wiring layer TM8 form wiring layers in which a feeding network and control lines of the antenna module 200 are provided. In this implementation, the first antenna radiator 250 is disposed on the surface of the first wiring layer TM1 away from the core layer 241, and the second antenna radiator 260 may be disposed in the third wiring layer TM3. As an example illustrated in FIG. 35, the first antenna radiator 250 is disposed on the surface of the first wiring layer TM1 and the second antenna radiator 260 is disposed in the third wiring layer TM3. It is noted that, in other implementations, the first antenna radiator 250 may be disposed on the surface of the first wiring layer TM1 away from the core layer 241, and the second antenna radiator 260 may be disposed in the second wiring layer TM2 or the fourth wiring layer TM4.

In an example, the first wiring layer TM1, the second wiring layer TM2, the third wiring layer TM3, the fourth wiring layer TM4, the sixth wiring layer TM6, the seventh wiring layer TM7, and the eighth wiring layer TM8 in the insulating substrate 240 are all electrically connected to the ground layer in the fifth wiring layer TM5. In an implementation, the first wiring layer TM1, the second wiring layer TM2, the third wiring layer TM3, the fourth wiring layer TM4, the sixth wiring layer TM6, the seventh wiring layer TM7, and the eighth wiring layer TM8 in the insulating substrate 240 all define through holes, and each through hole is filled with a metal material to be electrically coupled with the ground layer in the fifth wiring layer TM5, such that components in each wiring layer 242 are grounded.

In an example, the seventh wiring layer TM7 and the eighth wiring layer TM8 are further provided with power lines 271 and control lines 272. The power lines 271 and the control lines 272 are electrically coupled with the RF chip 230 respectively. The power lines 271 are used to provide the RF chip 230 with required power, and the control lines 272 are used to transmit control signals to the RF chip 230 to control the operation of the RF chip 230.

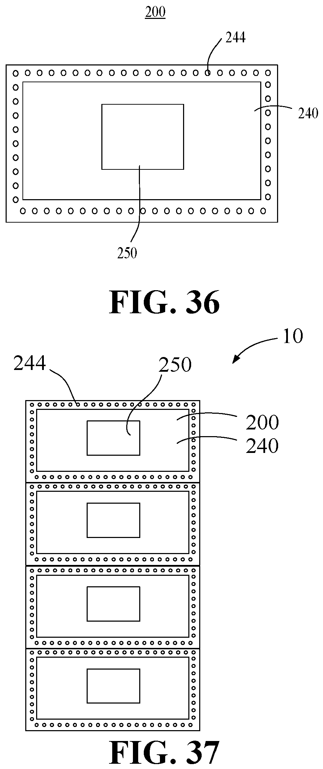

FIG. 36 is a schematic view of an RF antenna array consisting of *M* × *N* antenna assemblies according to an implementation of the present disclosure. The electronic device 1 includes the RF antenna array with *M* × *N* antenna assemblies 10, where *M* is a positive integer and N is a positive integer. As illustrated in FIG. 36, the RF antenna array includes 4 × 1 antenna assemblies 10. For each antenna module 200 in the antenna assembly 10, the insulating substrate 240 further defines multiple metallized via grids 244 arranged around each first antenna radiator 250 to improve isolation between two adjacent first antenna radiators 250. FIG. 37 is a schematic structural view of an RF antenna array constructed with packaged antenna modules according to an implementation of the present disclosure. When the metalized via grids 244 are defined in multiple antenna modules 200 to achieve a radiation frequency antenna array, the metalized via grids 244 are used to improve the isolation between two adjacent antenna modules 200, so as to reduce or even avoid the interference of millimeter wave signals generated by each antenna module 200.

An example that the antenna module 200 includes a patch antenna or a stacked antenna is given for illustration in the foregoing. It is noted that the antenna module 200 may further include a dipole antenna, a magnetic electric dipole antenna, a quasi-Yagi antenna, and the like. The antenna assembly 10 may include a combination consisting of at least one or more of a patch antenna, a stacked antenna, a dipole antenna, a magnetic dipole antenna, or a quasi-Yagi antenna. Further, the dielectric substrates of the *M* × *N* antenna assemblies 10 may be connected to each other into an integrated structure.

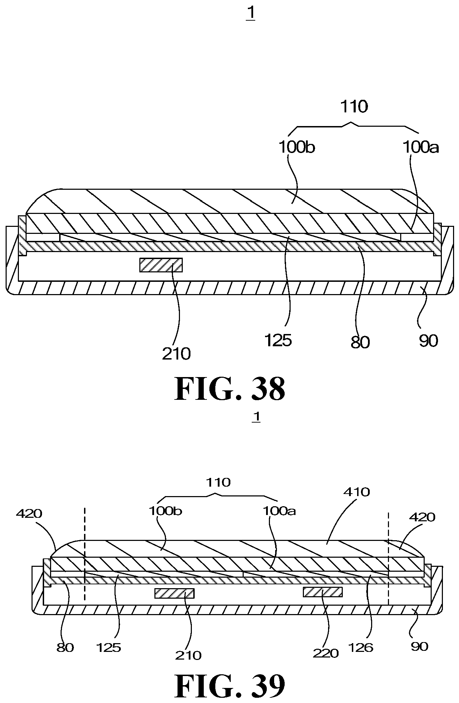

An electronic device 1 is further provided in the present disclosure. FIG. 38 is a schematic structural view of the electronic device 1 provided in the fourth implementation of the present disclosure. The electronic device 1 includes a first antenna module 210, a display screen body 110, and a first radio-wave transparent structure 125. The first antenna module 210 is configured to emit and receive, within a first preset direction range, a first radio frequency (RF) signal in a first frequency band. The display screen body 110 has a first transmittance to the RF signal in a preset frequency band, where the display screen body 110 is spaced apart from the first antenna module 210 and at least partially located within the first preset direction range. The first radio-wave transparent structure 125 is carried on the display screen body 110 and covers at least part of the display screen body 110, and is at least partially located within the first preset direction range. The electronic device 1 has a second transmittance to the first RF signal in the first frequency band in a region corresponding to the first radio-wave transparent structure 125, and the second transmittance is greater than the first transmittance.

The first radio-wave transparent structure 125 may be the radio-wave transparent structure described in any of the foregoing implementations. In an example, the electronic device 1 can further include a frame 80 and a battery cover 90. The frame 80 is used to carry the display screen body 110. The battery cover 90 and the display screen body 110 cooperate to define an accommodating space for accommodating the frame 80 and other electronic elements.

In a non-limiting example, as illustrated in FIG. 38, the display screen body 110 includes a display screen 100a and a cover plate 100b stacked with the display screen 100a. The first radio-wave transparent structure 125 is disposed on one side of the display screen 100a away from the cover plate 100b.

FIG. 39 is a schematic structural view of an electronic device provided in the fifth implementation of the present disclosure. The electronic device 1 in this implementation is identical to the electronic device 1 provided in the fourth implementation of the present disclosure except the following. In the fifth implementation, the electronic device 1 further includes a second antenna module 220 and a second radio-wave transparent structure 126. The second antenna module 220 is spaced apart from the first antenna module 210 and located outside the first preset direction range. The second antenna module 220 is configured to emit and receive, within a second preset direction range, a second RF signal in a second frequency band. The display screen body 110 is spaced apart from the second antenna module 220 and at least partially located within the second preset direction range. A part of the display screen body 110 within the second preset direction range has a third transmittance to the second RF signal in the second frequency band. A second radio-wave transparent structure 126 is carried on the display screen body 110. The second radio-wave transparent structure 126 is at least partially located within the second preset direction range. The electronic device 1 has a fourth transmittance to the second RF signal in the first frequency band in a region corresponding to the second radio-wave transparent structure 126, and the fourth transmittance is greater than the third transmittance.

Both of the first radio-wave transparent structure 125 and the second radio-wave transparent structure 126 can be the radio-wave transparent structure described in any of the forgoing implementations. In an example, the display screen body 110 includes a screen body 410 and an extending portion 420 bent and extended from a periphery of the screen body 110. Both of the first antenna module 210 and the second antenna module 220 are disposed corresponding to the screen body 410.

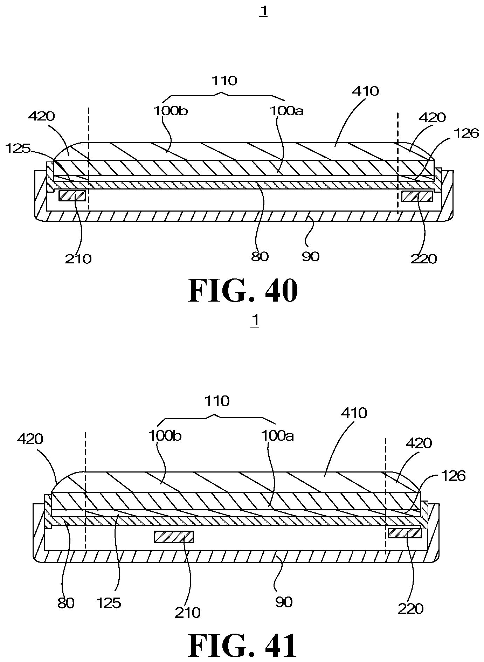

FIG. 40 is a schematic structural view of an electronic device provided in the sixth implementation of the present disclosure. The electronic device 1 provided in this implementation is identical to the electronic device 1 provided in the fifth implementation of the present disclosure except the following. In this implementation, both of the first antenna module 210 and the second antenna module 220 are disposed corresponding to the extending portion 420.

FIG. 41 is a schematic structural view of an electronic device provided in the seventh implementation of the present disclosure. The electronic device 1 provided in this implementation is substantially identical to the electronic device 1 provided in the fifth implementation of the present disclosure except the following. In this implementation, the first antenna module 210 is disposed corresponding to the screen body 410, and the second antenna module 220 is disposed corresponding to the extending portion 420.

Although the implementations of the present disclosure have been illustrated and described above, it can be understood that the above implementations are illustrative and cannot be understood as limitations on the present disclosure. Those skilled in the art can make changes, modifications, replacements, and variations for the above implementations within the scope of the present disclosure, and these improvements and modifications are also considered to fall into the protection scope of the present disclosure.

## Claims

1. A display screen assembly comprising:
a display screen body having a first transmittance to a radio frequency (RF) signal in a preset frequency band; and
a radio-wave transparent structure carried on the display screen body and covering at least part of the display screen body;
wherein the display screen assembly has a second transmittance to the RF signal in the preset frequency band in a region corresponding to the radio-wave transparent structure, the second transmittance being greater than the first transmittance.

2. The display screen assembly of claim 1, wherein the display screen body comprises a display screen and a cover plate stacked with the display screen, and the radio-wave transparent structure is disposed on the cover plate.

3. The display screen assembly of claim 1, wherein
the display screen body comprises an array substrate, wherein the array substrate comprises a substrate and a plurality of thin film transistors arranged in an array on the substrate;
the thin film transistor comprises a gate, a gate insulating layer, a channel layer, a source, and a drain, wherein the gate is disposed on one side of the substrate, the gate insulating layer covers the gate, the channel layer is disposed on the gate insulating layer and corresponds to the gate, the source and the drain are disposed at opposite ends of the channel layer and spaced apart from each other, and the source and the drain are both connected to the channel layer; and
the radio-wave transparent structure is a single-layer structure, and the radio-wave transparent structure is disposed in the same layer as the gate or disposed in the same layer as the source and the drain.

4. The display screen assembly of claim 1, wherein
the display screen body comprises an array substrate, wherein the array substrate comprises a substrate and a plurality of thin film transistors arranged in an array on the substrate;
the thin film transistor comprises a gate, a gate insulating layer, a channel layer, a source, and a drain, wherein the gate is disposed on one side of the substrate, the gate insulating layer covers the gate, the channel layer is disposed on the gate insulating layer and corresponds to the gate, the source and the drain are disposed at opposite ends of the channel layer and spaced apart from each other, and the source and the drain are both connected to the channel layer; and
the radio-wave transparent structure comprises a first radio-wave transparent layer and a second radio-wave transparent layer which are stacked and spaced apart from each other, wherein the first radio-wave transparent layer is disposed in the same layer as the gate, and the second radio-wave transparent layer is disposed in the same layer as the source and the drain.

5. The display screen assembly of claim 1, wherein
the display screen body comprises an array substrate, and the array substrate comprises a substrate and a plurality of thin film transistors arranged in an array on the substrate;
the thin film transistor comprises a light-shielding layer, a first insulating layer, a channel layer, a source, a drain, a second insulating layer, a gate, and a planarization layer, wherein the light-shielding layer is disposed on one side of the substrate, the first insulating layer covers the light-shielding layer, the channel layer is disposed on the first insulating layer and corresponds to the light-shielding layer, the source and the drain are disposed at opposite ends of the channel layer and spaced apart from each other, and the source and the drain are both connected to the channel layer, the second insulating layer covers the source and the drain, and the gate is disposed on the second insulating layer; and
the radio-wave transparent structure is a single-layer structure, wherein the radio-wave transparent structure is disposed in the same layer as one of the light-shielding layer and the gate or disposed in the same layer as the source and the drain.

6. The display screen assembly of claim 1, wherein
the display screen body comprises an array substrate, and the array substrate comprises a substrate and a plurality of thin film transistors arranged in an array on the substrate;
the thin film transistor comprises a light-shielding layer, a first insulating layer, a channel layer, a source, a drain, a second insulating layer, a gate, and a planarization layer, wherein the light-shielding layer is disposed on one side of the substrate, the first insulating layer covers the light-shielding layer, the channel layer is disposed on the first insulating layer and corresponds to the light-shielding layer, the source and the drain are disposed at opposite ends of the channel layer and spaced apart from each other, and the source and the drain are both connected to the channel layer, the second insulating layer covers the source and the drain, and the gate is disposed on the second insulating layer; and
the radio-wave transparent structure comprises a first radio-wave transparent layer and a second radio-wave transparent layer which are stacked and spaced apart from each other, wherein the first radio-wave transparent layer is disposed in the same layer as one of the light-shielding layer, the gate, and the source, and the second radio-wave transparent layer is disposed in the same layer as another one of the light-shielding layer, the gate, and the source.

7. The display screen assembly of claim 1, wherein
the display screen body comprises an array substrate, and the array substrate comprises a substrate and a plurality of thin film transistors arranged in an array on the substrate;
the thin film transistor comprises a light-shielding layer, a first insulating layer, a channel layer, a source, a drain, a second insulating layer, a gate, and a planarization layer, wherein the light-shielding layer is disposed on one side of the substrate, the first insulating layer covers the light-shielding layer, the channel layer is disposed on the first insulating layer and corresponds to the light-shielding layer, the source and the drain are disposed at opposite ends of the channel layer and spaced apart from each other, and the source and the drain are both connected to the channel layer, the second insulating layer covers the source and the drain, and the gate is disposed on the second insulating layer; and
the radio-wave transparent structure comprises a first radio-wave transparent layer, a second radio-wave transparent layer, and a third radio-wave transparent layer which are stacked and spaced apart from one another, wherein the first radio-wave transparent layer is disposed in the same layer as the light-shielding layer, the second radio-wave transparent layer is disposed in the same layer as the gate, and the third radio-wave transparent layer is disposed in the same layer as the drain.

8. The display screen assembly of claim 1, wherein
the display panel comprises an array substrate comprising a pixel electrode, wherein the pixel electrode is a semiconductor made of a transparent metal oxide material; and
the radio-wave transparent structure is at least partially disposed in the same layer as the pixel electrode and made of the same material as the pixel electrode.

9. The display screen assembly of claim 1, wherein
the display panel comprises an array substrate and a color filter substrate which are arranged opposite to and spaced apart from each other; and
the radio-wave transparent structure comprises a first radio-wave transparent layer and a second radio-wave transparent layer, wherein the first radio-wave transparent layer is disposed on the array substrate, and the second radio-wave transparent layer is disposed on the color filter substrate.

10. The display screen assembly of claim 9, wherein the color filter substrate comprises a pixel electrode, the array substrate comprises a common electrode, the first radio-wave transparent layer is disposed in the same layer as the pixel electrode, and the second radio-wave transparent layer is disposed in the same layer as the common electrode.

11. The display screen assembly of claim 1, wherein
the display screen body comprises a substrate and light-emitting elements arranged in an array on the substrate; the light-emitting element comprises a first electrode, a light-emitting layer, and a second electrode, wherein the first electrode is disposed more adjacent to the substrate than the light-emitting layer and the second electrode, the light-emitting layer is disposed on one side of the first electrode away from the substrate, and the second electrode is disposed on one side of the light-emitting layer away from the first electrode;
the first electrode is configured to load a first voltage, the second electrode is configured to load a second voltage, the light-emitting layer is configured to emit light under action of the first voltage and the second voltage; and
the radio-wave transparent structure is a single-layer structure, and the radio-wave transparent structure is disposed in the same layer as one of the first electrode and the second electrode.

12. The display screen assembly of claim 1, wherein
the display screen body comprises a substrate and light-emitting elements arranged in an array on the substrate; the light-emitting element comprises a first electrode, a light-emitting layer, and a second electrode, wherein the first electrode is disposed more adjacent to the substrate than the light-emitting layer and the second electrode, the light-emitting layer is disposed on one side of the first electrode away from the substrate, and the second electrode is disposed on one side of the light-emitting layer away from the first electrode;
the first electrode is configured to load a first voltage, the second electrode is configured to load a second voltage, the light-emitting layer is configured to emit light under action of the first voltage and the second voltage; and
the radio-wave transparent structure comprises a first radio-wave transparent layer and a second radio-wave transparent layer, wherein the first radio-wave transparent layer is disposed in the same layer as the first electrode, and the second radio-wave transparent layer is disposed in the same layer as the second electrode.

13. The display screen assembly of claim 11 or 12, wherein
the first electrode is an anode and the second electrode is a cathode; or
the first electrode is the cathode and the second electrode is the anode.

14. The display screen assembly of any of claims 4, 6, 9, and 12, wherein the first radio-wave transparent structure defines a through hole, and an orthographic projection of the second radio-wave transparent structure on the first radio-wave transparent structure falls within the through hole.

15. The display screen assembly of claim 1, wherein the display screen body comprises an inner surface and an outer surface opposite to the inner surface, and the radio-wave transparent structure is disposed on the inner surface.

16. The display screen assembly of claim 1, wherein the display screen body comprises a screen body and an extending portion bent and extended from a periphery of the screen body, and the radio-wave transparent structure is disposed corresponding to one of the screen body and the extending portion.

17. An antenna assembly, wherein the antenna assembly comprises an antenna module and the display screen assembly of any of claims 1-16, the antenna module is configured to emit and receive, within a preset range, the RF signal in the preset frequency band, and the radio-wave transparent structure in the display screen assembly is at least partially located within the preset range.

18. An electronic device comprising the antenna assembly of claim 17.

19. An electronic device, comprising:
a first antenna module configured to emit and receive, within a first preset direction range, a first radio frequency (RF) signal in a first frequency band;
a display screen body, wherein the display screen body is spaced apart from the first antenna module and at least partially located within the first preset direction range, and has a first transmittance to the RF signal in a preset frequency band; and
a first radio-wave transparent structure carried on the display screen body, wherein the first radio-wave transparent structure covers at least part of the display screen body and is at least partially located within the first preset direction range, and wherein the electronic device has a second transmittance to the first RF signal in the first frequency band in a region corresponding to the first radio-wave transparent structure, and the second transmittance is greater than the first transmittance.

20. The electronic device of claim 19, comprising:
a second antenna module spaced apart from the first antenna module and located outside the first preset direction range, wherein the second antenna module is configured to emit and receive, within a second preset direction range, a second RF signal in a second frequency band;
the display screen body is spaced apart from the second antenna module and at least partially located within the second preset direction range, and a part of the display screen body within the second preset direction range has a third transmittance to the second RF signal in the second frequency band; and
a second radio-wave transparent structure carried on the display screen body, wherein the second radio-wave transparent structure is at least partially located within the second preset direction range, and wherein the electronic device has a fourth transmittance to the second RF signal in the first frequency band in a region corresponding to the second radio-wave transparent structure, and the fourth transmittance is greater than the third transmittance.

21. The electronic device of claim 20, wherein the display screen body comprises a screen body and an extending portion bent and extended from a periphery of the screen body, wherein:
the first antenna module and the second antenna module are both disposed corresponding to the screen body; or
the first antenna module and the second antenna module are both disposed corresponding to the extending portion; or
the first antenna module is disposed corresponding to the screen body, and the second antenna module is disposed corresponding to the extending portion.
